# EUROPEAN PATENT SPECIFICATION

(11) **EP 4 300 722 B1**
(45) Date of publication and mention of the grant of the patent: **13.05.2026**
(21) Application number: 22190861.9
(22) Date of filing: 17.08.2022
(51) Int. Cl.: H01R 13/641, H01R 13/66, H01R 107/00, H01R 12/72

(54) **ELECTRONIC DEVICE FOR AN AUTOMOTIVE VEHICLE**
ELEKTRONISCHE VORRICHTUNG FÜR EIN KRAFTFAHRZEUG
DISPOSITIF ÉLECTRONIQUE POUR VÉHICULE AUTOMOBILE

(30) Priority: 30.06.2022 FR 2206702
(43) Date of publication of application: 03.01.2024
(73) Proprietor: Valeo Vision, 93012 Bobigny Cedex (FR)
(72) Inventor: MARTINEZ PEREZ, Jose Ramon, 23600 MARTOS (ES); RUBIA MENA, Juan Antonio, 23600 MARTOS (ES); MEDINA CAMACHO, Maria Pilar, 23600 MARTOS (ES); RUIZ SEDEÑO, Salvador, 23600 MARTOS (ES)
(74) Representative: Valeo Visibility

(56) References cited:
- WO-A1-2021/005134
- CN-U- 216 556 930
- FR-A1- 3 056 702

## Description

### TECHNICAL FIELD

This invention is related to the field of automotive lighting devices, and more particularly, to the electric connections between elements comprised therein.

### STATE OF THE ART

Card edge connections are massively used in different electronic assemblies. Automotive vehicles also make use of these connections in their lighting devices, where multitude of different channels need independent control electric signals.

The connection operation of a card edge connector is easy, since it relies on introducing a plane portion inside a female housing. No individual pins are used in these connections, so the risk of bending or breaking very thin elements is eliminated.

However, due to the ease of this connection operation, these two portions may be easily disconnected as well, and a reliable mechanism to detect an accidental disconnection is useful in these cases.

Connector position assurance pins are a good solution for this problem. One of the pins of the connector provides information about the connection state of the whole connector: if the connector position assurance pin is connected, the rest of the pins are connected for sure.

Document WO2021005134A1 discloses an electrical connection assembly including a connector having a verification contact intended for the transmission of an electrical signal for verifying the electrical connection between the connector and the printed circuit.

However, the main connector does not usually have such an amount of spare pins to be dedicated to this function.

A solution for this problem is therefore sought.

### SUMMARY OF THE INVENTION

The invention provides a solution for this problem by an electronic device for an automotive vehicle as defined in claim 1.

With such an arrangement, the main connector does not need extra terminals to transmit the information about connection position assurance, since the same bus connection of the driver may provide this information, in the shape of a measure input value, which is measured in one of its inputs.

Hence, this measure value provides a reliable information about the connector position assurance pin without the need of a dedicated pin in the main connector.

The concept of "terminals" is used as a generic way of referring to the elements which produce the electric contact between a wired portion of a connector and the corresponding receptacle portion. In some cases, the connector is needles connector, so the first terminals are spring plates and the second terminals are needles (or vice versa). In other embodiments, the connector is a card edge connector, so the receptacle portion are the tracks of the circuit, while the wired portion comprise the complementary tracks which are to be connected with the tracks of the circuit. Hence, the concept of terminals may be extended to any type of male-female electrical connection, especially the ones used in automotive electric connections.

In some embodiments, there is a single main power input but in other embodiments there are more than one main power input. This is a frequent arrangement when there is more than one function to be supplied.

In some particular embodiments, the electronic device further comprises a second module and a second module connector, wherein
the second module comprises a second electronic circuit mounted with an electronic element and a ground connection;
the second module connector comprises a wired portion comprising first terminals and a receptacle portion affixed on the second electronic circuit comprising second terminals, the second terminals being configured to match with the first terminals to establish an electric connection;
at least one of the second terminals is in electric connection with the at least one light source;
one of the first terminals is a first connector position assurance terminal and one of the second terminals is a second connector position assurance terminal, configured to provide information about the connection status with the first connector position assurance terminal;
the second connector position assurance terminal is connected to the ground connection by the interposition of a second connection impedance and the first connection impedance comprises at least a second resistor; and
the first connector position assurance terminal of the second connector is connected to the first connector position assurance terminal of the first connector.

The invention is particularly advantageous when more than one module is involved, since all the first connector position assurance terminals (no matter how many of them there are) are connected to the same measure input in the driver, without the need of a dedicated terminal in the main connector.

In some particular embodiments, the second connection resistor has a different value than the first connection resistor.

When more than one module is present, if each module is associated to a different resistor value, the resistor value measured at the measure input of the driver not only provides information about how many connectors are connected, but also provides information about which connector is connected or not: for a given failed connection (i.e., when the first CPA terminal is not connected to the corresponding second CPA terminal), the measurement value provides information to determine which is the specific connector that is not properly connected. This can be used for statistics on failed connections and so for better quality control and assembly procedures adjustment.

In some particular embodiments, the electronic element of the first electronic circuit and/or the electronic element of the second electronic circuit is a solid-state light source or an auxiliary electronic element which is configured to provide control or power supply to a solid-state light source.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the life span of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

The auxiliary electronic element may be a micro-controller or a driver, which is in charge of providing a controlled power to the light source.

In some particular embodiments, the connector connection position assurance pins are only connected with each other and with the measure input.

The first connection position assurance terminals have the relevant information of the connection status of the modules of the electronic device. Hence, when more than one module is present, it is enough that the first connection position assurance terminals are interconnected with each other to provide this information to the measure input of the driver element.

In some particular embodiments, the second connector position assurance terminal is configured to be the last in making electric contact with the corresponding first connector position assurance terminal.

One way to check electric connection between the wired portion and the receptacle portion is the fact that the electric connection between the first connector position assurance terminal and the second connector position assurance terminal is only performed once the connection between the rest of the terminals of the wired portion and the receptacle portion have taken place. One possible way of achieving this is by the second connector position assurance terminal ending at a distance from the connection line which is higher than the rest of the terminals. Since this second connector position assurance terminal ends "earlier", it is the last one to couple with their respective connector position assurance terminal. Hence, if this connector position assurance terminal is connected, it is sure that the rest of the terminals are connected as well. Other way of achieving this goal is by the first connector position assurance terminal being located at a different distance from the connection line that the rest of the first terminals. This is an alternative option based in the same principle: the second connector position assurance terminal is the last one to couple with their respective first connector position assurance terminal.

In some particular embodiments, the luminous device comprising a housing and an outer lens, wherein the joint between the housing and the outer lens is watertight, and wherein the housing comprises holes which are sealed in a watertight manner.

This watertight connection is required by some car manufacturers, and the present invention is able to provide it without compromising the solution of the main technical problem, which is the detection of the correct connection of the connectors without using a dedicated pin in the main connector.

In some particular embodiments, the main connector is the only connector accessible from the exterior of the region defined by the housing and the outer lens.

The fact that the main connector is the only connector which is accessible from the outside improves and simplifies the mechanical assembly within the automotive vehicle. Further, this arrangement helps in the sense that the main connector does not usually have many spare pins. Providing CPA information without using a pin of the main connector is also advantageous.

In some particular embodiments, each module connector is a card edge connector.

This is one of the most representative embodiments, although not the only one. In this case, the receptacle portion would be the portion of the tracks of the circuit which are to be contacted by the corresponding matching tracks of the wired portion of the connector.

In some particular embodiments, each electronic circuit is comprised in a corresponding printed circuit board, and at least one of the printed circuit boards has a retention portion which forms a retention element, such as a pair of resilient arms, configured for resiliently receive the card edge connector and retaining it after reception.

These retention means are advantageous to prevent an accidental disconnection of the connectors.

In some particular embodiments, the bus communication is Local Interconnect Network, LIN or Controller Area Network CAN or Clock Extension Peripheral Interface, CXPI.

In some particular embodiments, the driver element is configured to communicate the value of the measure input to the main connector using Unified Diagnostic Services.

In some particular embodiments, the driver device comprises a micro controller which integrates both the communication of the value of the measure input to the main connector and the bus communication interface.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

### BRIEF LIST OF DRAWINGS AND REFERENCE NUMBERS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a general perspective view of an automotive vehicle comprising an automotive lighting device according to the invention.
Figure 2 shows a scheme of the connection assembly of an automotive luminous device according to the invention.
Figures 3 and 4 show two alternative arrangements in each of the connectors, to provide to each connector (and therefore to each printed circuit board) the ability of inform about the connection position assurance.
Figure 5 shows a first example of a sub-circuit connecting the position assurance tracks and the corresponding electric contacts in an automotive luminous device according to the invention.
Figure 6 shows the connection of all the sub-circuits in an automotive luminous device according to the invention.

In these figures, the following reference numbers have been used:
- 1: Main PCB
- 2: Driver
- 3: Main connector
- 4: First secondary PCB
- 5: First secondary connector
- 6: Second secondary PCB
- 7: Second secondary connector
- 8: Heatsink
- 9: LED
- 10: Headlamp
- 11: Edge portion of the main PCB
- 12: Third secondary PCB
- 13: Third secondary connector
- 14: Edge portion of the third secondary PCB
- 15: Inputs of the third secondary connector
- 17: Electric tracks
- 20: Second CPA track
- 21: First branch
- 22: Second branch
- 23: Resistor
- 27: First CPA terminal
- 30: Lighting module
- 31: Electrical inputs of the main connector
- 32: Electrical outputs of the main connector
- 41: Edge portion of the first secondary PCB
- 51: Electrical inputs of the first secondary connector
- 52: Electrical outputs of the first secondary connector
- 61: Edge portion of the second secondary PCB
- 71: Electrical inputs of the second secondary connector
- 72: Electrical outputs of the second secondary connector
- 100: Automotive vehicle

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

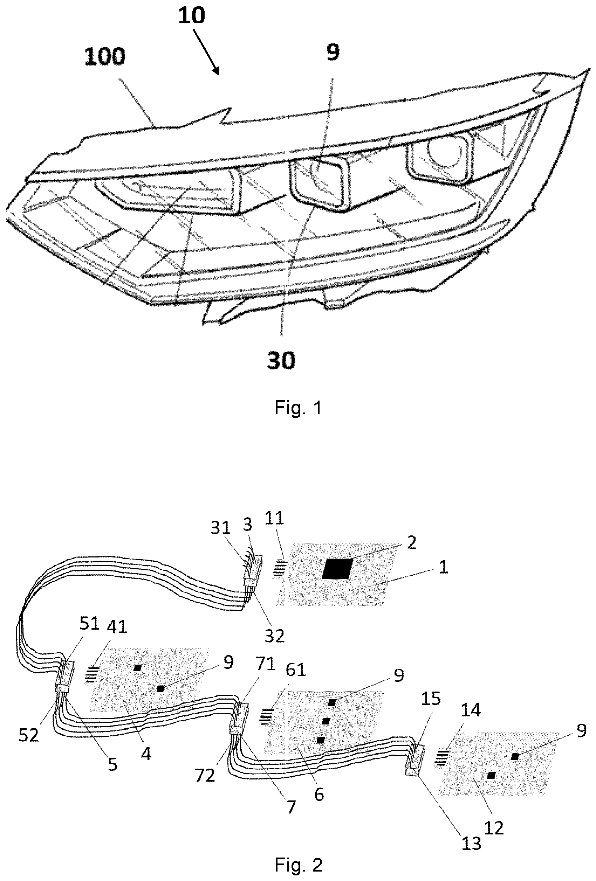

Figure 1 shows a general perspective view of an automotive lighting device 10 according to the invention.

This automotive lighting device 10 comprises a plurality of lighting modules 30. Each lighting module 30 comprises a plurality of light emitting diodes (LEDs) 9 arranged in a printed circuit board together with a driver configured to control the operation of these groups of LEDs.

The matrix configuration is a high-resolution module, having a resolution greater than 2000 pixels. However, no restriction is attached to the technology used for producing the projection modules.

A first example of this matrix configuration comprises a monolithic source. This monolithic source comprises a matrix of monolithic electroluminescent elements arranged in several columns by several rows. In a monolithic matrix, the electroluminescent elements can be grown from a common substrate and are electrically connected to be selectively activatable either individually or by a subset of electroluminescent elements. The substrate may be predominantly made of a semiconductor material. The substrate may comprise one or more other materials, for example non-semiconductors (metals and insulators). Thus, each electroluminescent element/group can form a light pixel and can therefore emit light when its/their material is supplied with electricity. The configuration of such a monolithic matrix allows the arrangement of selectively activatable pixels very close to each other, compared to conventional light-emitting diodes intended to be soldered to printed circuit boards. The monolithic matrix may comprise electroluminescent elements whose main dimension of height, measured perpendicularly to the common substrate, is substantially equal to one micrometre.

The monolithic matrix is coupled to the control centre so as to control the generation and/or the projection of a pixelated light beam by the matrix arrangement 6. The control centre is thus able to individually control the light emission of each pixel of the matrix arrangement.

Alternatively to what has been presented above, the matrix arrangement 6 may comprise a main light source coupled to a matrix of mirrors. Thus, the pixelated light source is formed by the assembly of at least one main light source formed of at least one light emitting diode emitting light and an array of optoelectronic elements, for example a matrix of micro-mirrors, also known by the acronym DMD, for "Digital Micro-mirror Device", which directs the light rays from the main light source by reflection to a projection optical element. Where appropriate, an auxiliary optical element can collect the rays of at least one light source to focus and direct them to the surface of the micro-mirror array.

Each micro-mirror can pivot between two fixed positions, a first position in which the light rays are reflected towards the projection optical element, and a second position in which the light rays are reflected in a different direction from the projection optical element. The two fixed positions are oriented in the same manner for all the micro-mirrors and form, with respect to a reference plane supporting the matrix of micro-mirrors, a characteristic angle of the matrix of micro-mirrors defined in its specifications. Such an angle is generally less than 20° and may be usually about 12°. Thus, each micro-mirror reflecting a part of the light beams which are incident on the matrix of micro-mirrors forms an elementary emitter of the pixelated light source. The actuation and control of the change of position of the mirrors for selectively activating this elementary emitter to emit or not an elementary light beam is controlled by the control centre.

In different embodiments, the matrix arrangement may comprise a scanning laser system wherein a laser light source emits a laser beam towards a scanning element which is configured to explore the surface of a wavelength converter with the laser beam. An image of this surface is captured by the projection optical element.

The exploration of the scanning element may be performed at a speed sufficiently high so that the human eye does not perceive any displacement in the projected image.

The synchronized control of the ignition of the laser source and the scanning movement of the beam makes it possible to generate a matrix of elementary emitters that can be activated selectively at the surface of the wavelength converter element. The scanning means may be a mobile micro-mirror for scanning the surface of the wavelength converter element by reflection of the laser beam. The micro-mirrors mentioned as scanning means are for example MEMS type, for "Micro-ElectroMechanical Systems". However, the invention is not limited to such a scanning means and can use other kinds of scanning means, such as a series of mirrors arranged on a rotating element, the rotation of the element causing a scanning of the transmission surface by the laser beam.

In another variant, the light source may be complex and include both at least one segment of light elements, such as light emitting diodes, and a surface portion of a monolithic light source.

Figure 2 shows a scheme of the connection assembly of an automotive luminous device according to the invention.

A main printed circuit board 1 comprises an electronic circuit. This electronic circuit starts in an edge portion 11 of the main printed circuit board 1 and communicate this edge portion 11 with a driver 2, which is intended to manage the lighting and signalling functions of the light sources located in the luminous device.

A main connector 3 is coupled to the edge portion 11 of the main substrate 1. This main connector 3 provides the main printed circuit board 1 with power supply and control signals coming from the body control module of the vehicle.

The main connector 3 comprises five electrical inputs 31 and five electrical outputs 32. The electrical inputs 31 are configured to transmit the power supply and the control signals to the main printed circuit board 1. To achieve this aim, they couple electrically to the electric tracks of the main substrate 1 when the main connector 3 is plugged into the edge portion 11 of the main printed circuit board 1.

The electrical outputs 32 are also coupled to the electrical tracks of the opposite side of the main printed circuit board 1.

There are also three secondary printed circuit boards 4, 6, 12. In different embodiments, there may be more secondary printed circuit boards, since the invention is not limited to a specific number of them.

Each secondary printed circuit boards 4, 6, 12 comprises a LED 9 and electric tracks which communicate the edge portions 41, 61, 14 of the corresponding secondary printed circuit board with the corresponding LED 9.

The LEDs 9 of each secondary printed circuit board 4, 6, 12 are intended to be controlled by the driver 2 of the main printed circuit board 1.

This control is achieved by means of a daisy-chain connection, as shown in Figure 1.

The main connector 3 is coupled to the edge portion 11 of the main printed circuit board 1. Each electrical input 31 is configured to receive power supply and control signals from the body control module and is electrically coupled to an electric track of the main printed circuit board 1. After feeding the circuit of the main printed circuit board 1, the electric tracks of the opposite side are coupled to the electrical outputs 32 of the main connector 3.

The first secondary connector 5 is coupled to the edge portion of the first secondary printed circuit board 4. The first secondary connector comprises five inputs 51, each input 51 being connected by wire with one output 32 of the main connector 3. After feeding the circuit of the first secondary printed circuit board 4, the electric tracks of the opposite side are coupled to the electrical outputs 52 of the first secondary connector 5.

The second secondary connector 7 is coupled to the edge portion of the second secondary printed circuit board 6. The second secondary connector 7 comprises five inputs 71, each input 71 being connected by wire with one output 52 of the first secondary connector 5. After feeding the circuit of the second secondary printed circuit board 6, the electric tracks of the opposite side are coupled to the electrical outputs 72 of the second secondary connector 7.

The third secondary connector 13 is coupled to the edge portion of the third secondary printed circuit board 12. The third secondary connector 13 comprises five inputs 15, each input 15 being connected by wire with one output 72 of the second secondary connector 7.

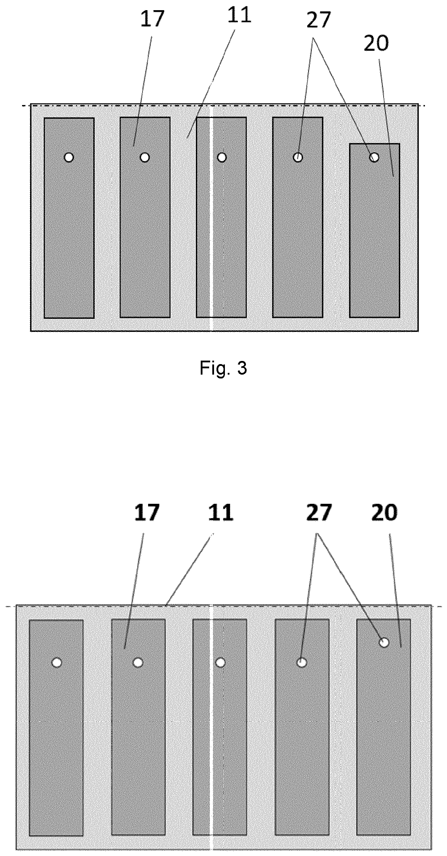

Figures 3 and 4 show two alternative arrangements in each of the connectors, to provide to each connector the ability of inform about the connection position assurance.

Figure 3 shows a first alternative to achieve this aim, showing the arrangement of the second connector position assurance track 20 and its respective first connector position assurance terminal 27 in a plan view.

Each conductive track 17 reaches its respective connector terminal and the second connector position assurance track 20 is shorter than the rest of the second tracks 17, thus ending at a distance from the edge of the connector 11 which is higher than the rest of the second tracks 17.

With this arrangement, the second connector position assurance track 20 is the last to be connected to its respective first connector position assurance terminal 27, thus ensuring that, if this connection is produced, the rest of the electric connections are achieved.

Figure 4 shows a second alternative to achieve this condition. In this case, the same aim of the embodiment of Figure 3 is achieved by the relative position of the first connector position assurance terminal 27 which intends to connect the second connector position assurance track 20. This first connector position assurance terminal 27 is located closer to the edge of the connector 11 than the rest of the first terminals. With this position, it is ensured that, when the second connector position assurance track 20 reaches its first connector position assurance terminal 27, the rest of the conductive tracks have reached theirs.

In both figures 3 and 4, it is seen how the second connector position assurance track is located on the external fifth of the line of conductive tracks. In this case, since there are only five tracks, this means that the connection position assurance track is located in the end of the conductive tracks (the more external one).

Therefore, with any of the embodiments shown in Figures 3 or 4 (or with any equivalent embodiment which provides a terminal with the possibility of transmitting information about connection position assurance), each printed circuit board has means to produce information about the connection position assurance.

This connection between the second connector position assurance track 20 and its corresponding first connector position assurance terminal feeds one sub-circuit which is independent from the one of the light source.

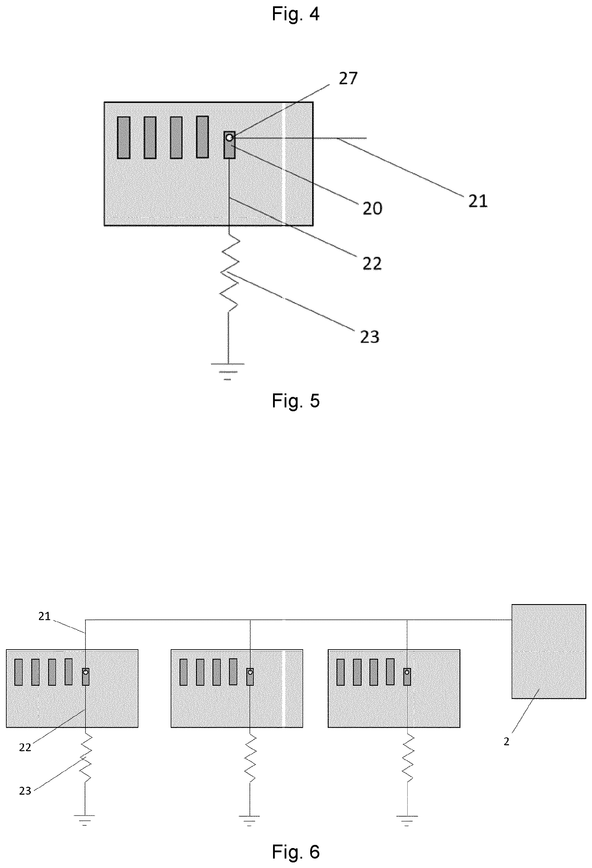

Figure 5 shows a first example of this sub-circuit. The components of this sub-circuit do not actively participate in the lighting function performed by the LEDs. The main function of this sub-circuit is to cooperate electrically with the contact between the second connector position assurance track 20 and its first connector position assurance terminal 27. The presence of current in this line of the circuit indicates that the connection is successfully achieved so all of the electric tracks are successfully coupled with the corresponding terminals of the wired portion of the connector.

This sub-circuit has a first branch 21, which contains the first connector position assurance terminal 27, and a second branch 22, which comprises a resistor 23 which is grounded. When the circuit is closed (i.e., when the second connector position assurance track is connected to the first connector position assurance terminal 27), the first branch sees the resistor value.

Figure 6 shows the connection of all the sub-circuits according to an embodiment of the invention. In this case, the first connector position assurance terminals are connected in parallel and the single connection is fed to a measure input of the driver 2, which is capable of measuring this equivalent resistor value.

Since each sub-circuit has its own resistor value, the signal at the measure input of the driver provides information about the connection state of every printed circuit board: if every connector is properly connected, the control output will see all the resistors in parallel. However, if one of them is not connected, the control output will see a different value, depending on which is the resistor that is not connected to the circuit. Thus, the control of all the printed circuit boards is performed with a single measure input in the driver.

The value of the measure input is communicated to the main connector using Unified Diagnostic Services. The driver device comprises a micro controller which integrates both the communication of the value of the measure input to the main connector and the bus communication interface.

## Claims

1. Electronic device (10) for an automotive vehicle (100), the electronic device (10) comprising a main connector (3), a first module connector (5), a first module (30) and a driver element (2), wherein
the main connector (3) comprises a at least a main power input terminal, a main ground terminal and a bus communication interface with the driver element (2);
the first module (30) comprises a first electronic circuit (5) mounted with an electronic element (9) and a ground connection which is in electrical connection with the main ground connection;
the first module connector (5) comprises a wired portion comprising first terminals (51) and a receptacle portion (41) affixed on the first electronic circuit (5) comprising second terminals (17), the second terminals (17) being configured to match with the first terminals to establish an electric connection;
at least one of the second terminals (17) is in electric connection with the electronic element (9);
**characterized in that**
one of the first terminals is a first connector position assurance terminal (27) and one of the second terminals is a second connector position assurance terminal (20), configured to provide information about the connection status with the first connector position assurance terminal (27);
the second connector position assurance terminal (20) is connected to the ground connection of the first electronic circuit (5) by the interposition of a first connection impedance and the first connection impedance comprises at least a first resistor (23); and
the driver element (2) is configured to manage the operation of the electronic element (9),
the driver element (2) comprises a measure input, the first connector position assurance terminal (27) being connected to the measure input, and
the driver element (2) is configured to communicate the value received at the measure input to the main connector via the bus communication interface.

2. Electronic device according to claim 1, further comprising a second module and a second module connector (7), wherein
the second module comprises a second electronic circuit (6) mounted with an electronic element (9) and a ground connection;
the second module connector (7) comprises a wired portion comprising first terminals (71) and a receptacle portion (61) affixed on the second electronic circuit (6) comprising second terminals, the second terminals being configured to match with the first terminals to establish an electric connection;
at least one of the second terminals is in electric connection with the at least one light source;
one of the first terminals is a first connector position assurance terminal (27) and one of the second terminals is a second connector position assurance terminal (20), configured to provide information about the connection status with the first connector position assurance terminal;
the second connector position assurance terminal is connected to the ground connection by the interposition of a second connection impedance and the first connection impedance comprises at least a second resistor; and
the first connector position assurance terminal (27) of the second connector (7) is connected to the first connector position assurance terminal (27) of the first connector (5).

3. Electronic device according to claim 2, wherein the second resistor has a different value than the first resistor.

4. Electronic device according to any of the preceding claims, wherein the electronic element of the first electronic circuit (5) and/or the electronic element of the second electronic circuit (7) is a solid-state light source (9) or an auxiliary electronic element which is configured to provide control or power supply to a solid-state light source (9).

5. Electronic device according to any of the preceding claims, wherein the first connector position assurance terminals (27) are only connected with each other and with the measure input.

6. Electronic device according to any of the preceding claims, wherein the second connector position assurance terminal (20) is configured to be the last in making electric contact with the corresponding first connector position assurance terminal (27).

7. Electronic device according to any of the preceding claims, further comprising a housing and an outer lens, wherein the joint between the housing and the outer lens is watertight, and wherein the housing comprises holes which are sealed in a watertight manner.

8. Electronic device according to claim 7, wherein the main connector (3) is the only connector accessible from the exterior of the region defined by the housing and the outer lens.

9. Electronic device according to any of the preceding claims, wherein each module connector (5, 7, 13) is a card edge connector.

10. Electronic device according to claim 9, wherein each electronic circuit is comprised in a corresponding printed circuit board (4, 6, 12), and at least one of the printed circuit boards has a retention portion which forms a retention element, such as a pair of resilient arms, configured for resiliently receive the card edge connector and retaining it after reception.

11. Electronic device according to any of the preceding claims, wherein the bus communication is Local Interconnect Network, LIN or Controller Area Network CAN or Clock Extension Peripheral Interface, CXPI.

12. Electronic device according to any of the preceding claims, wherein the driver element is configured to communicate the value of the measure input to the main connector using Unified Diagnostic Services.

13. Electronic device according to claim 12, wherein the driver device comprises a micro controller which integrates both the communication of the value of the measure input to the main connector and the bus communication interface.

## Patentansprüche

1. Elektronisches Gerät (10) für ein Kraftfahrzeug (100), wobei das elektronische Gerät (10) einen Hauptverbinder (3), einen ersten Modulverbinder (5), ein erstes Modul (30) und ein Treiberelement (2) umfasst, wobei
der Hauptverbinder (3) mindestens einen Hauptstromeingangsanschluss, einen Hauptmasseanschluss und eine Buskommunikationsschnittstelle mit dem Treiberelement (2) umfasst;
das erste Modul (30) eine erste elektronische Schaltung (5), die mit einem elektronischen Element (9) bestückt ist, und eine Masseverbindung umfasst, die in elektrischer Verbindung mit der Hauptmasseverbindung steht;
der erste Modulverbinder (5) einen verdrahteten Teil, der erste Anschlüsse (51) umfasst, und einen Aufnahmeteil (41), der an der ersten elektronischen Schaltung (5) befestigt ist und zweite Anschlüsse (17) umfasst, wobei die zweiten Anschlüsse (17) so konfiguriert sind, dass sie mit den ersten Anschlüssen übereinstimmen, um eine elektrische Verbindung herzustellen;
mindestens einer der zweiten Anschlüsse (17) in elektrischer Verbindung mit dem elektronischen Element (9) steht;
**dadurch gekennzeichnet, dass**
einer der ersten Anschlüsse ein erster Steckverbinder-Positionssicherungsanschluss (27) und einer der zweiten Anschlüsse ein zweiter Steckverbinder-Positionssicherungsanschluss (20) ist, der so konfiguriert ist, dass er Informationen über den Verbindungsstatus mit dem ersten Steckverbinder-Positionssicherungsanschluss (27) liefert;
der zweite Steckverbinder-Positionssicherungsanschluss (20) mit der Masseverbindung der ersten elektronischen Schaltung (5) durch die Zwischenschaltung einer ersten Verbindungsimpedanz verbunden ist und die erste Verbindungsimpedanz mindestens einen ersten Widerstand (23) umfasst; und
das Treiberelement (2) so konfiguriert ist, dass es den Betrieb des elektronischen Elements (9) steuert,
das Treiberelement (2) einen Messeingang umfasst, wobei der erste Steckverbinder-Positionssicherungsanschluss (27) mit dem Messeingang verbunden ist, und
das Treiberelement (2) so konfiguriert ist, dass es den am Messeingang empfangenen Wert über die Buskommunikationsschnittstelle an den Hauptverbinder übermittelt.

2. Elektronisches Gerät nach Anspruch 1, weiterhin umfassend ein zweites Modul und einen zweiten Modulverbinder (7), wobei
das zweite Modul eine zweite elektronische Schaltung (6), die mit einem elektronischen Element (9) bestückt ist, und eine Masseverbindung umfasst;
der zweite Modulverbinder (7) einen verdrahteten Teil, der erste Anschlüsse (71) umfasst, und einen Aufnahmeteil (61), der an der zweiten elektronischen Schaltung (6) befestigt ist und zweite Anschlüsse umfasst, wobei die zweiten Anschlüsse so konfiguriert sind, dass sie mit den ersten Anschlüssen übereinstimmen, um eine elektrische Verbindung herzustellen;
mindestens einer der zweiten Anschlüsse in elektrischer Verbindung mit der mindestens einen Lichtquelle steht;
einer der ersten Anschlüsse ein erster Steckverbinder-Positionssicherungsanschluss (27) und einer der zweiten Anschlüsse ein zweiter Steckverbinder-Positionssicherungsanschluss (20) ist, der so konfiguriert ist, dass er Informationen über den Verbindungsstatus mit dem ersten Steckverbinder-Positionssicherungsanschluss liefert;
der zweite Steckverbinder-Positionssicherungsanschluss mit der Masseverbindung durch die Zwischenschaltung einer zweiten Verbindungsimpedanz verbunden ist und die erste Verbindungsimpedanz mindestens einen zweiten Widerstand umfasst; und
der erste Steckverbinder-Positionssicherungsanschluss (27) des zweiten Verbinders (7) mit dem ersten Steckverbinder-Positionssicherungsanschluss (27) des ersten Verbinders (5) verbunden ist.

3. Elektronisches Gerät nach Anspruch 2, wobei der zweite Widerstand einen anderen Wert als der erste Widerstand hat.

4. Elektronisches Gerät nach einem der vorhergehenden Ansprüche, wobei das elektronische Element der ersten elektronischen Schaltung (5) und/oder das elektronische Element der zweiten elektronischen Schaltung (7) eine Festkörperlichtquelle (9) oder ein elektronisches Hilfselement ist, das so konfiguriert ist, dass es eine Steuerung oder Stromversorgung für eine Festkörperlichtquelle (9) bereitstellt.

5. Elektronisches Gerät nach einem der vorhergehenden Ansprüche, wobei die ersten Steckverbinder-Positionssicherungsanschlüsse (27) nur miteinander und mit dem Messeingang verbunden sind.

6. Elektronisches Gerät nach einem der vorhergehenden Ansprüche, wobei der zweite Steckverbinder-Positionssicherungsanschluss (20) so konfiguriert ist, dass er als letzter einen elektrischen Kontakt mit dem entsprechenden ersten Steckverbinder-Positionssicherungsanschluss (27) herstellt.

7. Elektronisches Gerät nach einem der vorhergehenden Ansprüche, weiterhin umfassend ein Gehäuse und eine äußere Linse, wobei die Verbindung zwischen dem Gehäuse und der äußeren Linse wasserdicht ist und wobei das Gehäuse Löcher aufweist, die wasserdicht abgedichtet sind.

8. Elektronisches Gerät nach Anspruch 7, wobei der Hauptverbinder (3) der einzige Verbinder ist, der von außerhalb des durch das Gehäuse und die äußere Linse definierten Bereichs zugänglich ist.

9. Elektronisches Gerät nach einem der vorhergehenden Ansprüche, wobei jeder Modulverbinder (5, 7, 13) ein Kartenkantenverbinder ist.

10. Elektronisches Gerät nach Anspruch 9, wobei jede elektronische Schaltung in einer entsprechenden Leiterplatte (4, 6, 12) enthalten ist und mindestens eine der Leiterplatten einen Rückhalteabschnitt aufweist, der ein Rückhalteelement bildet, wie zum Beispiel ein Paar elastischer Arme, die so konfiguriert sind, dass sie den Kartenkantenverbinder elastisch aufnehmen und nach der Aufnahme zurückhalten.

11. Elektronisches Gerät nach einem der vorhergehenden Ansprüche, wobei die Buskommunikation Local Interconnect Network, LIN oder Controller Area Network CAN oder Clock Extension Peripheral Interface, CXPI ist.

12. Elektronisches Gerät nach einem der vorhergehenden Ansprüche, wobei das Treiberelement so konfiguriert ist, dass es den Wert des Messeingangs unter Verwendung von Unified Diagnostic Services an den Hauptverbinder übermittelt.

13. Elektronisches Gerät nach Anspruch 12, wobei das Treibergerät einen Mikrocontroller umfasst, der sowohl die Übermittlung des Werts des Messeingangs an den Hauptverbinder als auch die Buskommunikationsschnittstelle integriert.

## Revendications

1. Dispositif électronique (10) pour un véhicule automobile (100), le dispositif électronique (10) comprenant un connecteur principal (3), un premier connecteur de module (5), un premier module (30) et un élément pilote (2), dans lequel
le connecteur principal (3) comprend au moins une borne d'entrée d'alimentation principale, une borne de masse principale et une interface de communication de bus avec l'élément pilote (2);
le premier module (30) comprend un premier circuit électronique (5) monté avec un élément électronique (9) et une connexion de masse qui est en connexion électrique avec la connexion de masse principale;
le premier connecteur de module (5) comprend une partie câblée comprenant des premières bornes (51) et une partie réceptacle (41) fixée sur le premier circuit électronique (5) comprenant des secondes bornes (17), les secondes bornes (17) étant configurées pour correspondre aux premières bornes afin d'établir une connexion électrique;
au moins l'une des secondes bornes (17) est en connexion électrique avec l'élément électronique (9);
**caractérisé en ce que**
l'une des premières bornes est une première borne d'assurance de position de connecteur (27) et l'une des secondes bornes est une seconde borne d'assurance de position de connecteur (20), configurées pour fournir des informations sur l'état de connexion avec la première borne d'assurance de position de connecteur (27);
la seconde borne d'assurance de position de connecteur (20) est connectée à la connexion de masse du premier circuit électronique (5) par l'interposition d'une première impédance de connexion et la première impédance de connexion comprend au moins une première résistance (23); et
l'élément pilote (2) est configuré pour gérer le fonctionnement de l'élément électronique (9),
l'élément pilote (2) comprend une entrée de mesure, la première borne d'assurance de position de connecteur (27) étant connectée à l'entrée de mesure, et
l'élément pilote (2) est configuré pour communiquer la valeur reçue à l'entrée de mesure au connecteur principal via l'interface de communication de bus.

2. Dispositif électronique selon la revendication 1, comprenant en outre un second module et un second connecteur de module (7), dans lequel
le second module comprend un second circuit électronique (6) monté avec un élément électronique (9) et une connexion de masse;
le second connecteur de module (7) comprend une partie câblée comprenant des premières bornes (71) et une partie réceptacle (61) fixée sur le second circuit électronique (6) comprenant des secondes bornes, les secondes bornes étant configurées pour correspondre aux premières bornes afin d'établir une connexion électrique;
au moins l'une des secondes bornes est en connexion électrique avec l'au moins une source de lumière;
l'une des premières bornes est une première borne d'assurance de position de connecteur (27) et l'une des secondes bornes est une seconde borne d'assurance de position de connecteur (20), configurées pour fournir des informations sur l'état de connexion avec la première borne d'assurance de position de connecteur;
la seconde borne d'assurance de position de connecteur est connectée à la connexion de masse par l'interposition d'une seconde impédance de connexion et la première impédance de connexion comprend au moins une seconde résistance; et
la première borne d'assurance de position de connecteur (27) du second connecteur (7) est connectée à la première borne d'assurance de position de connecteur (27) du premier connecteur (5).

3. Dispositif électronique selon la revendication 2, dans lequel la seconde résistance a une valeur différente de la première résistance.

4. Dispositif électronique selon l'une quelconque des revendications précédentes, dans lequel l'élément électronique du premier circuit électronique (5) et/ou l'élément électronique du second circuit électronique (7) est une source de lumière à semi-conducteurs (9) ou un élément électronique auxiliaire qui est configuré pour fournir un contrôle ou une alimentation électrique à une source de lumière à semi-conducteurs (9).

5. Dispositif électronique selon l'une quelconque des revendications précédentes, dans lequel les premières bornes d'assurance de position de connecteur (27) sont uniquement connectées entre elles et avec l'entrée de mesure.

6. Dispositif électronique selon l'une quelconque des revendications précédentes, dans lequel la seconde borne d'assurance de position de connecteur (20) est configurée pour être la dernière à établir un contact électrique avec la première borne d'assurance de position de connecteur correspondante (27).

7. Dispositif électronique selon l'une quelconque des revendications précédentes, comprenant en outre un boîtier et une lentille extérieure, dans lequel le joint entre le boîtier et la lentille extérieure est étanche à l'eau, et dans lequel le boîtier comprend des trous qui sont scellés de manière étanche à l'eau.

8. Dispositif électronique selon la revendication 7, dans lequel le connecteur principal (3) est le seul connecteur accessible depuis l'extérieur de la région définie par le boîtier et la lentille extérieure.

9. Dispositif électronique selon l'une quelconque des revendications précédentes, dans lequel chaque connecteur de module (5, 7, 13) est un connecteur de bord de carte.

10. Dispositif électronique selon la revendication 9, dans lequel chaque circuit électronique est compris dans une carte de circuit imprimé correspondante (4, 6, 12), et au moins l'une des cartes de circuit imprimé a une partie de rétention qui forme un élément de rétention, tel qu'une paire de bras élastiques, configurée pour recevoir élastiquement le connecteur de bord de carte et le retenir après réception.

11. Dispositif électronique selon l'une quelconque des revendications précédentes, dans lequel la communication de bus est Local Interconnect Network, LIN ou Controller Area Network CAN ou Clock Extension Peripheral Interface, CXPI.

12. Dispositif électronique selon l'une quelconque des revendications précédentes, dans lequel l'élément pilote est configuré pour communiquer la valeur de l'entrée de mesure au connecteur principal en utilisant les Services de Diagnostic Unifiés.

13. Dispositif électronique selon la revendication 12, dans lequel le dispositif pilote comprend un microcontrôleur qui intègre à la fois la communication de la valeur de l'entrée de mesure au connecteur principal et l'interface de communication de bus.
